# EUROPÄISCHE PATENTSCHRIFT

(11) **EP 2 432 914 B1**
(45) Veröffentlichungstag und Bekanntmachung des Hinweises auf die Patenterteilung: **13.02.2013**
(21) Anmeldenummer: 10710577.7
(22) Anmeldetag: 22.03.2010
(51) Int. Cl.: C23C 14/06, C23C 14/02

(54) **VERSCHLEIßSCHUTZSCHICHTANORDNUNG SOWIE BAUELEMENT MIT VERSCHLEIßSCHUTZSCHICHTANORDNUNG**
ANTI-WEAR LAYER ARRANGEMENT AND STRUCTURAL ELEMENT HAVING AN ANTI-WEAR LAYER ARRANGEMENT
AGENCEMENT DE COUCHE DE PROTECTION ANTI-USURE ET COMPOSANT AVEC AGENCEMENT DE COUCHE DE PROTECTION ANTI-USURE

(30) Priorität: 18.05.2009 DE 102009003192
(43) Veröffentlichungstag der Anmeldung: 28.03.2012
(73) Patentinhaber: Robert Bosch GmbH, 70442 Stuttgart (DE)
(72) Erfinder: FRAUNE, Michael, 70499 Stuttgart (DE); FEUERFEIL, Rainer, 70839Gerlingen (DE); MAY, Ulrich, 71277 Rutesheim (DE)
(86) Internationale Anmeldenummer: PCT/EP2010/053701
(87) Internationale Veröffentlichungsnummer: WO 2010/133388

(56) Entgegenhaltungen:
- WO-A1-2005/068825
- WO-A1-2007/020138
- WO-A2-2007/109714
- DE-A1- 10 038 954
- DE-A1-102004 041 235
- DE-A1-102004 054 193
- TREUTLER ET AL: "Industrial use of plasma-deposited coatings for components of automotive fuel injection systems" SURFACE AND COATINGS TECHNOLOGY, ELSEVIER, AMSTERDAM, NL, Bd. 200, Nr. 5-6, 21. November 2005 (2005-11-21), Seiten 1969-1975, XP005173251 ISSN: 0257-8972

## Beschreibung

### Stand der Technik

Die Erfindung betrifft eine Verschleißschutzschichtanordnung, insbesondere für hohen Drücken und Temperaturen ausgesetzte Bauteile eines Kraftstoffeinspritzsystems gemäß dem Oberbegriff des Anspruchs 1 sowie ein Bauelement gemäß Anspruch 7.

Bei Bauelementen in der Einspritztechnik wird serienmäßig von der Anmelderin eine metallfreie, amorphe, wasserstoffhaltige Kohlenstoffschicht (a-C:H-Schicht) als Verschleißschutzschicht zur Minderung von Reibung und Verschleiß eingesetzt. Die Dicke der durch plasmatechnische Verfahren auf der Bauelementoberfläche aufgetragenen Kohlenstoffschicht beträgt dabei typischerweise zwischen 1 µm und 3 µm.

Ferner werden auf Bauelementen tetragonal amorphe, wasserstofffreie Kohlenstoffschichten (ta-C-Schichten) eingesetzt, die sich gegenüber den a-C:H-Schichten durch verbesserte Eigenschaften auszeichnen. Um die ta-C-Schicht haftfest auf das Bauelement aufbringen zu können, wird die ta-C-Schicht als Bestandteil einer Verschleißschutzschichtanordnung vorgesehen, die zusätzlich zu der ta-C-Schicht eine Haftvermittlerschicht aus plasmaunterstützt abgeschiedenem Titan aufweist. Es bestehen, inbesondere im Hinblick auf die in der Einspritztechnologie immer weiter steigenden Drücke und Temperaturen, Bestrebungen, die Haftfestigkeit von ta-C-Schichten auf Bauelementeoberflächen zu verbessern.

### Offenbarung der Erfindung

Mit der Erfindung wird erreicht, eine Verschleißschutzschichtanordnung derart weiterzubilden, dass sie bei relativ hohen Temperaturen unter inerten oder oxidierenden Gasatmosphären eine höhere Haftfähigkeit aufweist. Der Erfindung liegt dabei die Idee zugrunde, der aus Titan bestehenden Haftvermittlerschicht zusätzlich ein Element eines oxidationsbeständigen Elementes zuzumengen. Durch diesen Bestandteil wird die hohe chemische Reaktivität von Titan vermindert bzw. die Oxydationsbeständigkeit der Haftvermittlerschicht erhöht und somit insgesamt die Haftfähigkeit der Schutzschichtanordnung erhöht.

Vorteilhafte Weiterbildungen der erfindungsgemäßen Verschleißschutzschichtanordnung, insbesondere für hohen Drücken und hohen Temperaturen ausgesetzte Bauelemente eines Kraftstoffeinspritzsystems, sind in den Unteransprüchen und der nachfolgenden Beschreibung angegeben.
Als vorteilhaft hat es sich herausgestellt, wenn das Element zumindest ein Element aus der Gruppe der Elemente Niob, Chrom, Vanadium, Silizium, Nickel, Praseodym, Molybdän oder Tantal ist.

Besonders vorteilhaft ist es hierbei, wenn der Anteil des wenigstens einen oxidationsbeständigen Elementes zwischen 1 % und 40 % der Haftvermittlerschicht beträgt.

Besonders bevorzugt ist es, die Haftvermittlerschicht mittels eines PVD-Verfahrens (physikalische Gasphasenabscheidung) unmittelbar auf die Oberfläche des zu beschichtenden, vorzugsweise zumindest im zu beschichtenden Bereich aus Stahl bestehenden ersten Bauteils aufzubringen.

Idealerweise wird auch die Schutzschicht selbst mittels eines PVD-Verfahrens, vorzugsweise unter Vakuum, aufgebracht.

Gute Ergebnisse im Hinblick auf eine optimierte Haftfestigkeit der Verschleißschutzschichtanordnung werden erreicht, wenn die Haftvermittlerschicht eine Schichtdicke aus einem Wertebereich zwischen etwa 50 nm und etwa 300 nm aufweist. Besonders bevorzugt ist die Gesamtdicke der Verschleißschichtanordnung aus einem Wertebereich zwischen etwa 1 µm und 10 µm gewählt.

Die Erfindung führt auch auf ein Bauelement, insbesondere eines Kraftstoffeinspritzsystems. Ganz besonders bevorzugt besteht das Bauelement, zumindest in dem zu beschichtenden Bereich, aus Stahl. Das Bauelement zeichnet sich durch eine nach dem Konzept der Erfindung ausgebildete, zuvor beschriebene Verschleißschichtanordnung aus. Ganz besonders bevorzugt handelt es sich bei dem Bauelement um ein Bestandteil eines Kraftstoff-Injektors, insbesondere um eine Düsennadel. Ebenso kann es sich bei dem Bauelement um ein Bestandteil einer Kraftstoff-Hochdruckpumpe handeln.

Weitere Vorteile, Merkmale und Einzeilheiten der Erfindung ergeben sich aus der nachfolgenden Beschreibung bevorzugter Ausführungsbeispiele sowie anhand der Zeichnungen.

Diese zeigen in:
- Fig. 1:: einen schematischen Schichtaufbau mittels einer Haftvermittlerschicht nach dem Stand der Technik, und
- Fig. 2:: eine erfindungsgemäße Verschleißschutzschichtanordnung, ebenfalls in einer schematischen Ansicht.

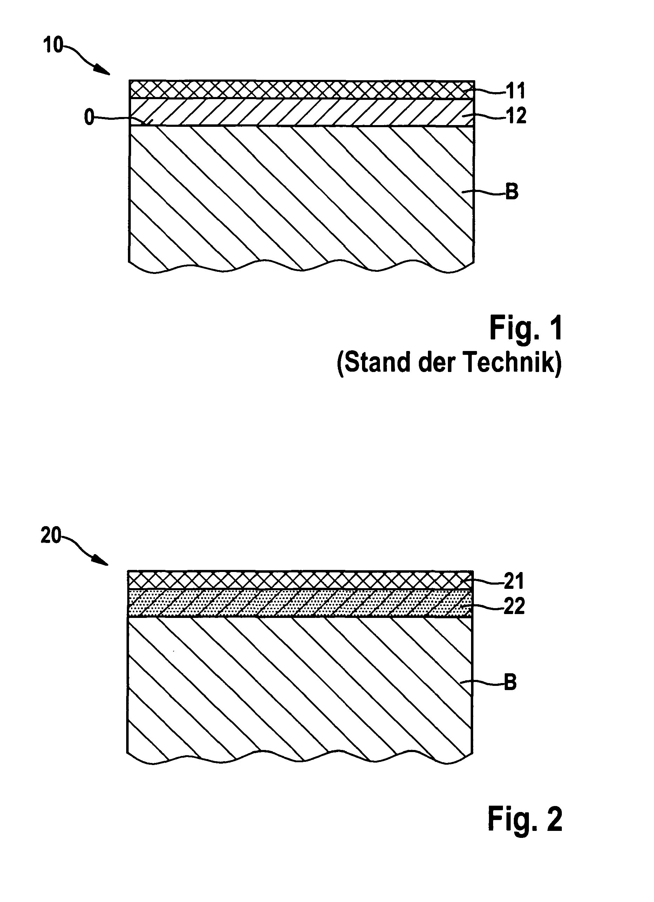

In der Fig. 1 ist eine Verschleißschutzschichtanordnung 10 nach dem Stand der Technik aufgezeigt. Die Verschleißschutzschichtanordnung 10 weist eine Schutzschicht 11 auf, die tetragonal gebundenen amorphen Kohlenstoff, oder einen Anteil an tetragonal gebundendem amorphen Kohlenstoff enthält. Die Schutzschicht 11 ist unter Zwischenlage einer Haftvermittlerschicht 12 auf einem Bauteil B angeordnet. Die Haftvermittlerschicht 12 besteht aus reinem Titan und weist eine Schichtdicke von ca. 40 nm bis 100 nm auf. Demgegenüber beträgt die Schichticke der Schutzschicht 11 zwischen 2 µm und 5 µm. Die Haftvermittlerschicht 12 ist unmittelbar auf der Oberfläche O des Bauteils B aufgebracht.

In der Fig. 2 ist eine erfindungsgemäße Verschleißschutzschichtanordnung 20 dargestellt. Die Verschleißschutzschichtanordnung 20 enthält eine Schutzschicht 21, die identisch zur Schutzschicht 11 bei der Verschleißschutzschichtanordnung 10 aufgebaut sein kann, d.h. insbesondere aus tetragonal gebundenem amorphen Kohlenstoff besteht, oder Anteile von tetragonal gebundenem amorphen Kohlenstoff enthält. Die Schutzschicht 21 ist unter Zwischenlage einer Haftvermittlerschicht 22 auf dem Bauteil B unmittelbar auf dessen Oberfläche O aufgebracht.

Die Haftvermittlerschicht 22 besteht erfindungsgemäß aus Titan und zusätzlich aus einem oxidationsbeständigen Element. Vorzugsweise handelt es sich bei dem oxidationsbeständigen Element um wenigstens ein Element aus der Gruppe der Elemente Niob, Chrom, Vanadium, Silizium, Nickel, Praseodym, Molybdän oder Tantal. Besonders bevorzugt handelt es sich dabei um die Elemente Silizium oder Niob bzw. um eine Kombination der Elemente Silizium und Niob. Der Anteil des wenigstens einen oxidationsbeständigen Elementes an der Gesamt-Haftvermittlerschicht 22 beträgt zwischen 1 % und 40 %, vorzugsweise zwischen 10% und 20%. Die Haftvermittlerschicht 22 ist mittels eines PVD-Verfahrens auf die Oberfläche O des Bauteils B aufgebracht.

Nach dem Aufbringen der Haftvermittlerschicht 22 wird die Schutzschicht 21 vorzugsweise ebenfalls im PVD-Verfahren, hierbei insbesondere unter Vakuum auf die Haftvermittlerschicht 22 aufgebracht. Hierbei beträgt die Gesamtdicke der aus der Schutzschicht 21 und der Haftvermittlerschicht 22 bestehenden Verschleißschutzschichtanordnung 20 zwischen etwa 1µm und 10 µm. Bei dem Bauteil B handelt es sich insbesondere um ein Bauteil B eines Kraftstoff-Einspritzsystems, das vorzugsweise zumindest in dem zu beschichtenden Bereich des Bauteils B aus Stahl besteht. Hierbei ist das Bauteil B insbesondere Bestandteil eines Kraftstoff-Injektors, insbesondere eine Düsennadel, oder ein Bestandteil einer Kraftstoff-Hochdruckpumpe.

## Patentansprüche

1. Verschleißschutzschichtanordnung (20) für hohen Drücken und hohen Temperaturen ausgesetzten Bauelementen (B) eines Kraftstoffeinspritzsystems, mit einer aus tetragonal gebundenem amorphen Kohlenstoff gebildeten oder einen Anteil an tetragonal gebundenem amorphen Kohlenstoff aufweisenden Schutzschicht (21), sowie einer Titan aufweisenden Haftvermittlerschicht (22) zwischen dem Bauelement (B) und der Schutzschicht (21),
**dadurch gekennzeichnet,**
**dass** die Haftvermittlerschicht (22) zusätzlich neben Titan wenigstens ein oxidationsbeständiges Element enthält, das die hohe chemische Reaktivität von Titan vermindert bzw. die Oxidationsbeständigkeit der Haftvermittlerschicht (22) erhöht.

2. Verschleißschutzschichtanordnung nach Anspruch 1,
**dadurch gekennzeichnet,**
**dass** das wenigstens eine oxydationsbeständige Element ein Element aus der Gruppe der Elemente Niob, Chrom, Vanadium, Silizium, Nickel, Praseodym, Molybdän oder Tantal ist.

3. Verschleißschutzeinrichtung nach Anspruch 1 oder 2,
**dadurch gekennzeichnet,**
**dass** der Anteil des wenigstens einen oxidationsbeständigen Elementes zwischen 1 % und 40 %, insbesondere zwischen 10% und 20% beträgt.

4. Verschleißschutzschichtanordnung nach einem der Ansprüche 1 bis 3,
**dadurch gekennzeichnet,**
**dass** die Haftvermittlerschicht (22) mittels eines PVD-Verfahrens auf dem Bauteil (B) aufgebracht ist.

5. Verschleißschutzschichtanordnung nach einem der Ansprüche 1 bis 4,
**dadurch gekennzeichnet,**
**dass** die Schutzschicht (21) im Vakuum-PVD-Verfahren auf die Haftvermittlerschicht (22) aufgebracht ist.

6. Verschleißschutzschichtanordnung nach Anspruch 4 oder 5,
**dadurch gekennzeichnet,**
**dass** die Haftvermittlerschicht (22) eine Schichtdicke von 50 nm bis 300 nm aufweist.

7. Verschleißschutzschichtanordnung nach einem der Ansprüche 1 bis 6,
**dadurch gekennzeichnet,**
**dass** die Gesamtdicke der Verschleißschutzschichtanordnung (20) aus einem Wertebereich zwischen etwa 1 µm und 10 µm gewählt ist.

8. Bauelement, insbesondere eines Kraftstoffeinspritzsystems, vorzugsweise aus Stahl, mit einer Verschleißschutzschichtanordnung (20) nach einem der Ansprüche 1 bis 7.

9. Bauelement nach Anspruch 8,
**dadurch gekennzeichnet,**
**dass** das Bauelement (B) Bestandteil eines Kraftstoff-Injektors, insbesondere eine Düsennadel, oder ein Bestandteil einer Kraftstoff-Hochdruckpumpe ist.

## Claims

1. Anti-wear layer arrangement (20) for structural elements (B) of a fuel injection system which are exposed to high pressures and high temperatures, comprising a protective layer (21) which is formed from tetragonally bonded amorphous carbon or comprises a proportion of tetragonally bonded amorphous carbon, and also an adhesion promoter layer (22) comprising titanium between the structural element (B) and the protective layer (21),
**characterized**
**in that** the adhesion promoter layer (22) additionally comprises, in addition to titanium, at least one oxidation-resistant element, which reduces the high chemical reactivity of titanium or increases the oxidation resistance of the adhesion promoter layer (22).

2. Anti-wear layer arrangement according to Claim 1,
**characterized**
**in that** the at least one oxidation-resistant element is an element selected from the group consisting of the elements niobium, chromium, vanadium, silicon, nickel, praseodymium, molybdenum and tantalum.

3. Anti-wear layer arrangement according to Claim 1 or 2,
**characterized**
**in that** the proportion of the at least one oxidation-resistant element is between 1% and 40%, in particular between 10% and 20%.

4. Anti-wear layer arrangement according to one of Claims 1 to 3,
**characterized**
**in that** the adhesion promoter layer (22) is applied to the component (B) by means of a PVD process.

5. Anti-wear layer arrangement according to one of Claims 1 to 4,
**characterized**
**in that** the protective layer (21) is applied to the adhesion promoter layer (22) by a vacuum PVD process.

6. Anti-wear layer arrangement according to Claim 4 or 5,
**characterized**
**in that** the adhesion promoter layer (22) has a layer thickness of 50 nm to 300 nm.

7. Anti-wear layer arrangement according to one of Claims 1 to 6,
**characterized**
**in that** the total thickness of the anti-wear layer arrangement (20) is selected from a range of values of between approximately 1 µm and 10 µm.

8. Structural element, in particular of a fuel injection system, preferably made of steel, comprising an anti-wear layer arrangement (20) according to one of Claims 1 to 7.

9. Structural element according to Claim 8,
**characterized**
**in that** the structural element (B) is a component part of a fuel injector, in particular a nozzle needle, or a component part of a high-pressure fuel pump.

## Revendications

1. Ensemble (20) de couche de protection contre l'usure pour composants (B) d'un système d'injection de carburant exposés à des hautes pressions et à des hautes températures, l'ensemble présentant
une couche de protection (21) formée de carbone amorphe à liaison tétragonale ou présentant une teneur en carbone amorphe relié par des liaisons tétragonales ainsi qu'une couche (22) de renforcement de l'adhérence présentant du titane et prévue entre le composant (B) et la couche de protection (21),
**caractérisé en ce que**
en plus du titane, la couche (22) de renforcement de l'adhérence contient au moins un élément résistant à l'oxydation, qui diminue la haute réactivité chimique du titane et qui augmente la résistance à l'oxydation de la couche (22) de renforcement de l'adhérence.

2. Ensemble de couche de protection contre l'usure selon la revendication 1, **caractérisé en ce qu'**au moins un élément résistant à l'oxydation est un élément de l'ensemble constitué des éléments niobium, chrome, vanadium, silicium, nickel, praséodyme, molybdène et tantale.

3. Ensemble de couche de protection contre l'usure selon les revendications 1 ou 2, **caractérisé en ce que** la teneur en le ou les éléments résistant à l'oxydation est comprise entre 1 % et 40 % et en particulier entre 10 % et 20 %.

4. Ensemble de couche de protection contre l'usure selon l'une des revendications 1 à 3, **caractérisé en ce que** la couche (22) de renforcement de l'adhérence est appliquée sur le composant (B) par une opération de PVD.

5. Ensemble de couche de protection contre l'usure selon l'une des revendications 1 à 4, **caractérisé en ce que** la couche de protection (21) est appliquée sur la couche (22) de renforcement de l'adhérence par un procédé de PVD sous vide.

6. Ensemble de couche de protection contre l'usure selon les revendications 4 ou 5, **caractérisé en ce que** la couche (22) de renforcement de l'adhérence présente une épaisseur comprise entre 50 nm et 300 nm.

7. Ensemble de couche de protection contre l'usure selon l'une des revendications 1 à 6, **caractérisé en ce que** l'épaisseur totale de l'ensemble (20) de couche de protection contre l'usure est sélectionnée dans une plage de valeurs comprise entre environ 1 µm et 10 µm.

8. Composant notamment pour système d'injection de carburant, de préférence en acier, et doté d'un ensemble (20) de couche de protection contre l'usure selon l'une des revendications 1 à 7.

9. Composant selon la revendication 8, **caractérisé en ce que** le composant (B) fait partie d'un injecteur de carburant, notamment d'un pointeau d'injecteur, ou est un composant d'une pompe de carburant à haute pression.
